# EUROPEAN PATENT SPECIFICATION

(11) **EP 3 182 256 B1**
(45) Date of publication and mention of the grant of the patent: **08.02.2023**
(21) Application number: 16202966.4
(22) Date of filing: 08.12.2016
(51) Int. Cl.: G06F 3/041, G06F 3/044, H03K 17/96, H03K 17/975

(54) **TOUCH CONTROL BUTTON, TOUCH CONTROL PANEL AND TOUCH CONTROL TERMINAL**
BERÜHRUNGSSTEUERUNGSKNOPF, BERÜHRUNGSSTEUERUNGSTAFEL UND BERÜHRUNGSSTEUERUNGSENDGERÄT
BOUTON DE COMMANDE TACTILE, PANNEAU DE COMMANDE TACTILE ET TERMINAL DE COMMANDE TACTILE

(30) Priority: 16.12.2015 CN 201510946737
(43) Date of publication of application: 21.06.2017
(73) Proprietor: Xiaomi Inc., Beijing 100085 (CN)
(72) Inventor: WANG, Gang, BEIJING, 100085 (CN); JIANG, Zhongsheng, BEIJING, 100085 (CN); HU, Shaoxing, BEIJING, 100085 (CN)
(74) Representative: Cabinet Beau de Loménie

(56) References cited:
- CN-A- 101 741 931
- KR-A- 20120 000 630
- US-A1- 2010 079 404
- US-A1- 2011 175 845
- US-A1- 2012 068 965
- US-A1- 2014 028 575
- US-A1- 2014 176 485

## Description

### TECHNICAL FIELD

The present invention relates to a touch control terminal.

### BACKGROUND

With the pressure sensitive control technology, a pressing strength is sensed by a pressure sensitive control device, and thus feedbacks may be provided in response to touch control actions belonging to three aspects such as clicking, slight pressing and heavy pressing.

In the prior art, the pressure sensitive control technology is mainly applied in a view area of a touch control panel. However, for a touch control button out of the view area, the touch control may be realized through a self capacitance or mutual capacitance of a sensing channel independent of the view area, while the pressure sensitive touch control cannot be realized. US 2014/176485 A1 discloses a touch screen comprising a processor being configured to determine based on a sensed capacitance a force resulting from a touch action.

US 2014/028575 A1 discloses a computing device for detecting user input.

### SUMMARY

In order to overcome problems existing in the prior art, embodiments of the present invention provide a touch control terminal.

In order to solve the above problems, embodiments of the present invention provide technical solutions as follows.

According to a first aspect, the invention relates to a touch control terminal according to claim 1.

Further embodiments are recited in the dependent claims.

The technical solutions provided in embodiments of the present invention may have following advantageous effects. The touch control button provided in embodiments of the present invention includes the touch sensing layer, the pressure sensing layer and the shielding layer. The pressure sensing layer is right below the touch sensing layer and the shielding layer is right below the pressure sensing layer. When a finger or a touch subject presses on the touch control button, the gap between the pressure sensing layer and the shielding layer becomes smaller, such that the electric signal sensed by the pressure sensing layer changes, and then a strength of the pressure made by the finger or the touch subject may be determined according to the change of the electric signal. Since the touch control button may be used for realizing the sense of the pressure sensitive touch control of the touch subject, the touch control terminal provided with the touch control button may response to the pressure sensitive touch control action. In this way, apart from the perspective of the "duration" of long press gesture, the human-machine interaction based on the touch control button may be realized from the perspective of the "strength" of pressure, thus enriching levels and usage experience of the human-machine interaction.

It is to be understood that both the foregoing general description and the following detailed description are exemplary and explanatory only and are not restrictive of the invention.

### BRIEF DESCRIPTION OF THE DRAWINGS

Accompanying drawings herein are incorporated in and constitute a part of the specification, and illustrate example embodiments in line with the present invention, and serve to explain the principle of the present invention together with the description.
Fig. 1 is a schematic diagram of a touch control terminal provided with a touch control button in the prior art.
Fig. 2 is a section view of a touch control button according to an unclaimed embodiment.
Fig. 3 is a section view of another touch control button according to an example embodiment.
Fig. 4 is a section view of a touch control panel according to an example embodiment.
Fig. 5 is a schematic diagram illustrating wires of a pressure sensing layer according to an example embodiment.
Fig. 6 is a schematic diagram of a touch control terminal according to an example embodiment.

Embodiments of the present invention are illustrated in the above accompany drawings and will be described in further detail hereinafter. These accompany drawings and literal description are not intended to limit the scope of the present invention, but to explain the principle of the present invention with reference to particular embodiments for those skilled in the art.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

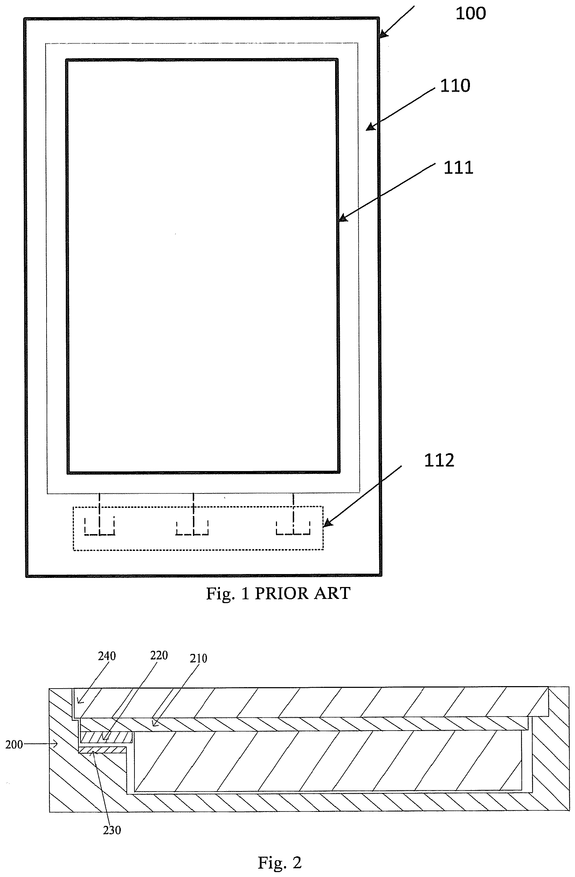

The present invention is explained in combination with Fig. 1 and Fig. 2, in which Fig. 1 is a schematic diagram of a touch control terminal provided with a touch control button in the prior art, and Fig. 2 is a section view of a touch control button according to an example embodiment.

As shown in Fig. 1, a touch control panel 100 on a touch control terminal 110 includes a view area (VA) 111 and a touch control button area 112 independent of the view area. The touch control button area may realize the touch control via a self-capacitance or mutual capacitance of an independent sensing channel.

As shown in Fig. 2, the touch control button area according to an example embodiment includes a touch sensing layer 210, a pressure sensing layer 220 and a shielding layer 230.

The touch sensing layer 210 is located at the top, and configured to sense a touch operation (such as, clicking, double-clicking, long-pressing, etc.) performed on the touch control button by a touch subject.

The pressure sensing layer 220 is located right below the touch sensing layer 210 in the touch control button area. The pressure sensing layer 220 may be directly attached to a bottom of the touch sensing layer 210 via conductive adhesive.

The shielding layer 230 is located right below the pressure sensing layer 220 and at a preset distance from the pressure sensing layer 220. Further, the shielding layer 230 is grounded. The pressure sensing layer 220 is configured to sense a pressing operation on the touch control button by the touch subject. For example, different operations correspond respectively to different strengths of pressure.

In this embodiment, a distance between the pressure sensing layer 220 and the shielding layer 230 approximates to the vertical distance between the pressure sensing layer and a body of the touch control terminal that carries the touch control panel.

In an example embodiment not covered by the claims, as shown in Fig. 2, the shielding layer 230 is attached to the body 200 of the touch control terminal right below the pressure sensing layer.

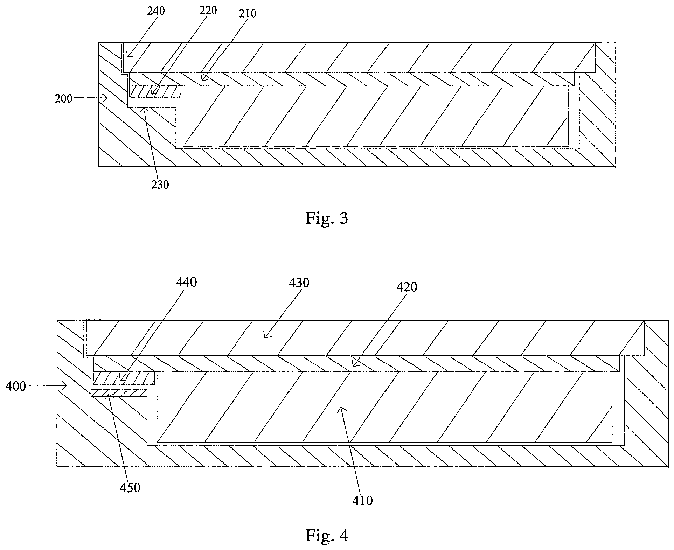

As shown in Fig. 3, the metal body is be configured as the shielding layer, such that no further shielding layer is required. The pressure sensing layer 220 may be made of any one from indium tin oxide (ITO), and a metal film (such as silver) printed on polyethylene terephthalate (PET) base material. In embodiments not covered by the claims, the shielding layer 230 may be made of any one from indium tin oxide (ITO), and a metal film (such as silver) printed on polyethylene terephthalate (PET) base material.

Each one of the above materials is easy to acquire and has a low cost, thus the overall cost of the touch control button is low.

A capacitance may be formed between the pressure sensing layer 220 and the shielding layer 230. When a finger presses the touch control button, the distance between the pressure sensing layer 220 and the shielding layer 230 becomes smaller, such that the electric signal sensed by the pressure sensing layer changes, and the strength of the pressure for pressing the touch control button may be determined according to the change of electric signal.

In addition, a protective layer 240 is located above the touch sensing layer 210, and configured to protect respective sensing layers below the protective layer 240. The protective layer 240 is typically reinforced glass.

The touch control button according to this embodiment includes the touch sensing layer, the pressure sensing layer and the shielding layer. The pressure sensing layer is located below the touch sensing layer, and the shielding layer is located below the pressure sensing layer. When a finger or a touch subject presses on the touch control button, the gap between the pressure sensing layer and the shielding layer becomes smaller, such that the electric signal sensed by the pressure sensing layer changes, and the strength of the pressure of the finger or the touch subject may be determined according to the change of the electric signal. Since the touch control button may be used for realizing the sense of pressure sensitive touch control of the touch subject, the touch control terminal provided with the touch control button may response to the pressure sensitive touch control operation. In this way, apart from the perspective of the "duration" of long press gesture, the human-machine interaction based on the touch control button may be realized from the perspective of the "strength" of pressure, thus enriching levels and usage experience of the human-machine interaction.

Corresponding to the above touch control button, the present invention further provides embodiments of a touch control panel provided with the touch control button.

Fig. 4 is a section view of a touch control panel according to an example embodiment. As shown in Fig. 4, the touch control panel includes a view area and a touch control button area.

The view area includes a display screen 410, a touch sensing layer 420 and a protective layer 430. Besides the protective layer 430 and the touch sensing layer 420, the touch control button area also includes a pressure sensing layer 440 and a shielding layer 450. That is, both the protective layer 430 and the touch sensing layer 420 may cover the view area and the touch control button area.

In the view area, the display screen 410 is located at the bottom, the touch sensing layer 420 is located above the display screen 410, and the protective layer 430 is located above the touch sensing layer 420.

In the touch control button area, the pressure sensing layer 440 is located below the touch sensing layer 420 in the touch control button area. The shielding layer 450 is located below the pressure sensing layer 440 and a certain gap is formed therebetween. The shielding layer 450 is grounded.

In an example embodiment of the present invention, the shielding layer 450 is attached to a body of a touch control terminal 400 right below the pressure sensing layer 440, in which the touch control terminal is provided with the touch control panel.

In another example embodiment of the present invention, if the body of the touch control terminal provided with the touch control panel, which carries the touch control screen, is made of metal, the metal body may be directly configured as the shielding layer, without the need of adding an additional shielding layer.

In this embodiment, each of the pressure sensing layer 440 and the shielding layer 450 may be made of any one of ITO, FPC and a metal film (such as, silver) printed on PET.

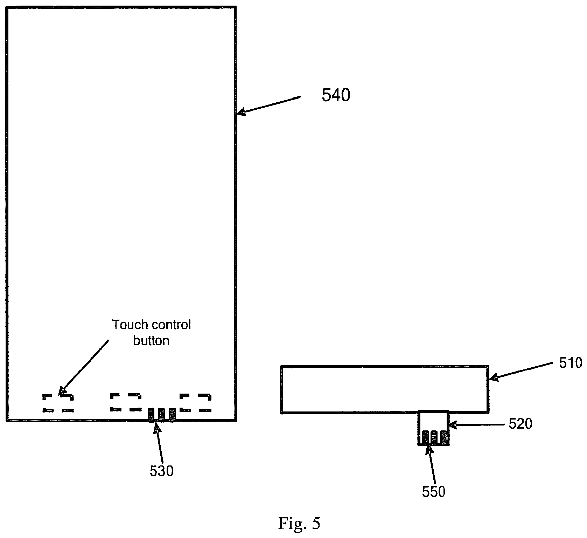

Fig. 5 is a schematic diagram illustrating wires of a pressure sensing layer according to an example embodiment. As shown in Fig. 5, a flexible conductive board 520 is arranged at an edge of the pressure sensing layer 510, and the flexible conductive board 520 is provided with a first kind of bonding pad 550. At the same time, the touch sensing layer 540 is provided with a second kind of bonding pad 530 at a position corresponding to the first kind bonding pad 550. Further, the second kind of bonding pad is connected to a touch control chip via wires of the touch sensing layer.

After the pressure sensing layer 510 is attached to a bottom of the touch sensing layer 540, the first kind of bonding pad 550 is electrically connected to the second kind of bonding pad 530, such that the wires of the pressure sensing layer 510 are connected to the touch control chip via the wires of the touch sending layer 540, thus ensuring that the touch control chip can not only detect pressure sensitive touch control operations but also detect touch operations.

The touch control panel according to this embodiment includes the view area and the touch control button area independent of the view area. The touch control button area includes the touch sensing layer, the pressure sensing layer and the shielding layer. The pressure sensing layer is located below the touch sensing layer, and the shielding layer is located below the pressure sensing layer. When a finger or a touch subject presses on the touch control button, the gap between the pressure sensing layer and the shielding layer becomes smaller, such that the electric signal sensed by the pressure sensing layer changes, and the strength of the pressure of the finger or the touch subject may be determined according to the change of the electric signal. Since the touch control button may be used for realizing the sense of pressure sensitive touch control of the touch subject, the touch control terminal provided with the touch control button may response to the pressure sensitive touch control operation. In this way, apart from the perspective of the "duration" of long press gesture, the human-machine interaction based on the touch control button may be realized from the perspective of the "strength" of pressure, thus enriching levels and usage experience of the human-machine interaction.

With respect to the device in the above embodiments, specific manners for respective modules performing operations have been described in detail in related method embodiments and detailed descriptions thereof are omitted herein.

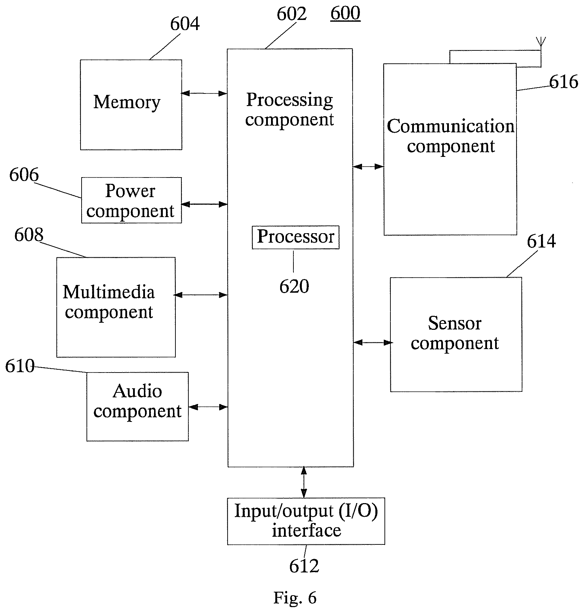

Fig. 6 is a block diagram of a touch control terminal 600 according to an embodiment of the present invention. For example, the touch control terminal 600 may be a mobile phone, a computer, a digital broadcast terminal, a message transceiver, a game console, a tablet device, a medical equipment, a fitness equipment or a personal digital assistance etc.

Referring to Fig. 6, the touch control terminal 600 may include one or more of the following components: a processing component 602, a memory 604, a power component 606, a multimedia component 608, an audio component 610, an input/output (I/O) interface 612, a sensor component 614, and a communication component 616.

The processing component 602 typically controls overall operations of the touch control terminal 600, such as the operations associated with display, telephone calls, data communications, camera operations, and recording operations. The processing component 602 may include one or more processors 520 to execute instructions to perform all or part of the steps in the above described methods. Moreover, the processing component 602 may include one or more modules which facilitate the interaction between the processing component 602 and other components. For instance, the processing component 602 may include a multimedia module to facilitate the interaction between the multimedia component 608 and the processing component 602.

The memory 604 is configured to store various types of data to support the operation of the touch control terminal 600. Examples of such data include instructions for any applications or methods operated on the touch control terminal 600, contact data, phonebook data, messages, pictures, video, etc. The memory 604 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 606 provides power to various components of the touch control terminal 600. The power component 606 may include a power management system, one or more power sources, and any other components associated with the generation, management, and distribution of power in the touch control terminal 600.

The multimedia component 608 includes a screen providing an output interface between the touch control terminal 600 and the user. In some embodiments, the screen may include a liquid crystal display (LCD) and a touch panel (TP). If the screen includes the touch control panel, the screen may be implemented as a touch screen to receive input signals from the user. The touch control panel includes one or more touch sensors to sense touches, swipes, and gestures on the touch control panel. The touch sensors may not only sense a boundary of a touch or swipe action, but also sense a period of time and a pressure associated with the touch or swipe action.

In some embodiments, the touch control panel further includes a touch control button. The touch control button may be a capacitor button. A touch control button area includes the protective layer, the touch sensing layer, the pressure sensing layer and the shielding layer. The pressure sensing layer is located below the touch sensing layer, and the shielding layer is located below the pressure sensing layer and at a preset distance from the pressure sensing layer. A capacitance is formed between the pressure sensing layer and the shielding layer, when a finger presses the touch control button, the distance between the pressure sensing layer and the shielding layer becomes smaller, such that the electric signal sensed by the pressure sensing layer changes, and the strength of the pressure for pressing the touch control button may be determined according to the change of the electric signal. Further, the processing component 602 may perform different operations according to different strengths of pressure.

In some embodiments, the multimedia component 608 includes a front camera and/or a rear camera. The front camera and the rear camera may receive an external multimedia datum while the touch control terminal 600 is in an operation mode, such as a photographing mode or a video mode. Each of the front camera and the rear camera may be a fixed optical lens system or have focus and optical zoom capability.

The audio component 610 is configured to output and/or input audio signals. For example, the audio component 610 includes a microphone ("MIC") configured to receive an external audio signal when the touch control terminal 600 is in an operation mode, such as a call mode, a recording mode, and a voice recognition mode. The received audio signal may be further stored in the memory 604 or transmitted via the communication component 616. In some embodiments, the audio component 610 further includes a speaker to output audio signals.

The I/O interface 612 provides an interface between the processing component 602 and peripheral interface modules, such as a keyboard, a click wheel, buttons, and the like. The buttons may include, but are not limited to, a home button, a volume button, a starting button, and a locking button.

The sensor component 614 includes one or more sensors to provide status assessments of various aspects of the touch control terminal 600. For instance, the sensor component 614 may detect an open/closed status of the touch control terminal 600, relative positioning of components, e.g., the display and the keypad, of the touch control terminal 600, a change in position of the touch control terminal 600 or a component of the touch control terminal 600, a presence or absence of user contact with the touch control terminal 600, an orientation or an acceleration/deceleration of the touch control terminal 600, and a change in temperature of the touch control terminal 600. The sensor component 614 may include a proximity sensor configured to detect the presence of nearby objects without any physical contact. The sensor component 614 may also include a light sensor, such as a CMOS or CCD image sensor, for use in imaging applications. In some embodiments, the sensor component 614 may also include an accelerometer sensor, a gyroscope sensor, a magnetic sensor, a pressure sensor, or a temperature sensor.

The communication component 616 is configured to facilitate communication, wired or wirelessly, between the touch control terminal 600 and other devices. The touch control terminal 600 can access a wireless network based on a communication standard, such as WiFi, 2G, or 3G, or a combination thereof. In one exemplary embodiment, the communication component 616 receives a broadcast signal or broadcast associated information from an external broadcast management system via a broadcast channel. In one exemplary embodiment, the communication component 616 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the touch control terminal 600 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In exemplary embodiments, there is also provided a non-transitory computer-readable storage medium including instructions, such as included in the memory 604, executable by the processor 620 in the touch control terminal 600, for performing the above-described methods. For example, the non-transitory computer-readable storage medium may be a ROM, a RAM, a CD-ROM, a magnetic tape, a floppy disc, an optical data storage device, and the like.

Other embodiments of the invention will be apparent to those skilled in the art from consideration of the specification and practice of the invention disclosed here.

## Claims

1. A touch control terminal (600) comprising a touch control button and a touch control chip, the touch control button comprising a touch sensing layer (210; 420; 540), a pressure sensing layer (220; 440; 510) and a shielding layer (230; 450),
the pressure sensing layer (220; 440; 510) being located right below the touch sensing layer (210; 420; 540) in a touch control button area;
the shielding layer (230; 450) being a metal body of the touch control terminal located right below the pressure sensing layer (220; 440; 510) and at a preset distance from the pressure sensing layer (220; 440; 510), wherein a capacitance is formed between the pressure sensing layer (220) and the metal body of the terminal,
a flexible conductive board (520) being arranged at an edge of the pressure sensing layer (220; 440; 510), wherein the flexible conductive board (520) is provided with a first kind of bonding pad (550); and,
the touch sensing layer (210; 420; 540) being provided with a second kind of bonding pad (530) at a position corresponding to the first kind of bonding pad (550), wherein the second kind of bonding pad (530) is configured to be electrically connected to the touch control chip.

2. The touch control terminal according to claim 1, wherein the pressure sensing layer (220; 440; 510) is directly attached to a bottom of the touch sensing layer (210; 420; 540) in the touch control button area via conductive adhesive.

3. The touch control terminal (600) according to claim 1 or 2, comprising a touch control panel (100), the touch control panel (100) comprising a view area and the touch control button area, wherein
the touch control button area is located in an area independent of the view area;
the view area comprises a display screen (410), the display screen (410) comprises the touch sensing layer (420; 540), and the touch sensing layer (420; 540) comprises a protective layer (430);
the touch control button area comprises the protective layer (430) and the touch control button.

4. The touch control terminal (600) according to claim 3, comprising a processor, the processor being configured to:
detect a touch control signal on the display screen (410), and perform a first operation according to the touch control signal; and
detect a touch pressing signal of the touch control button, and perform a second operation according to the touch pressing signal.

## Patentansprüche

1. Berührungssteuerendgerät (600), das eine Berührungssteuertaste und einen Berührungssteuerchip umfasst, wobei die Berührungssteuertaste eine Berührungserfassungsschicht (210; 420; 540), eine Druckerfassungsschicht (220; 440; 510) und eine Schirmungsschicht (230; 450) umfasst,
wobei sich die Druckerfassungsschicht (220; 440; 510) rechts unter der Berührungserfassungsschicht (210; 420; 540) in einem Bereich der Berührungssteuertaste befindet;
wobei die Schirmungsschicht (230; 450) ein Metallkörper des Berührungssteuerendgeräts ist, der sich rechts unter der Druckerfassungsschicht (220; 440; 510) und in einem voreingestellten Abstand von der Druckerfassungsschicht (220; 440; 510) befindet, wobei zwischen der Druckerfassungsschicht (220) und dem Metallkörper des Endgeräts eine Kapazität gebildet ist,
eine flexible leitfähige Platine (520), die an einer Kante der Druckerfassungsschicht (220; 440; 510) angeordnet ist, wobei die flexible leitfähige Platine (520) mit einer ersten Art von Bondingauflage (550) versehen ist; und
wobei die Berührungserfassungsschicht (210; 420; 540) in einer Position, die der ersten Art von Bondingauflage (550) entspricht, mit einer zweiten Art von Bondingauflage (530) versehen ist, wobei die zweite Art von Bondingauflage (530) dazu ausgelegt ist, mit dem Berührungssteuerchip elektrisch verbunden zu sein.

2. Berührungssteuerendgerät nach Anspruch 1, wobei die Druckerfassungsschicht (220; 440; 510) im Bereich der Berührungssteuertaste via einen leitfähigen Kleber direkt an einem Boden der Berührungserfassungsschicht (210; 420; 540) befestigt ist.

3. Berührungssteuerendgerät (600) nach Anspruch 1 oder 2, das ein Berührungssteuerpaneel (100) umfasst, wobei das Berührungssteuerpaneel (100) einen Sichtbereich und den Bereich der Berührungssteuertaste umfasst, wobei
der Bereich der Berührungssteuertaste sich in einem Bereich befindet, der vom Sichtbereich unabhängig ist;
der Sichtbereich einen Anzeigebildschirm (410) umfasst, der Anzeigebildschirm (410) die Berührungserfassungsschicht (420; 540) umfasst und die Berührungserfassungsschicht (420; 540) eine Schutzschicht (430) umfasst;
der Bereich der Berührungssteuertaste die Schutzschicht (430) und die Berührungssteuertaste umfasst.

4. Berührungssteuerendgerät (600) nach Anspruch 3, das einen Prozessor umfasst, wobei der Prozessor zu Folgendem ausgelegt ist:
Detektieren eines Berührungssteuersignals auf dem Anzeigebildschirm (410) und Durchführen einer ersten Operation gemäß dem Berührungssteuersignal; und
Detektieren eines Berührungsdrucksignals der Berührungssteuertaste und Durchführen einer zweiten Operation gemäß dem Berührungsdrucksignal.

## Revendications

1. Terminal de commande tactile (600) comprenant un bouton de commande tactile et une puce de commande tactile, le bouton de commande tactile comprenant une couche de détection tactile (210 ; 420 ; 540), une couche de détection de pression (220 ; 440 ; 510) et une couche de protection (230 ; 450),
la couche de détection de pression (220 ; 440 ; 510) étant située juste en dessous de la couche de détection tactile (210 ; 420 ; 540) dans une zone de bouton de commande tactile ;
la couche de protection (230 ; 450) étant un corps métallique du terminal de commande tactile situé juste en dessous de la couche de détection de pression (220 ; 440 ; 510) et à une distance prédéfinie de la couche de détection de pression (220 ; 440 ; 510), dans lequel une capacité est formée entre la couche de détection de pression (220) et le corps métallique du terminal,
une carte conductrice flexible (520) étant agencée au niveau d'un bord de la couche de détection de pression (220 ; 440 ; 510), dans lequel la carte conductrice flexible (520) est pourvue d'un premier type de plot de connexion (550) ; et,
la couche de détection tactile (210 ; 420 ; 540) étant pourvue d'un deuxième type de plot de connexion (530) à une position correspondant au premier type de plot de connexion (550), dans lequel le deuxième type de plot de connexion (530) est configuré pour être connecté électriquement à la puce de commande tactile.

2. Terminal de commande tactile selon la revendication 1, dans lequel la couche de détection de pression (220 ; 440 ; 510) est directement fixée à un fond de la couche de détection tactile (210 ; 420 ; 540) dans la zone de bouton de commande tactile via un adhésif conducteur.

3. Terminal de commande tactile (600) selon la revendication 1 ou 2, comprenant un panneau de commande tactile (100), le panneau de commande tactile (100) comprenant une zone de visualisation et la zone de bouton de commande tactile, dans lequel
la zone de bouton de commande tactile est située dans une zone indépendante de la zone de visualisation ;
la zone de visualisation comprend un écran d'affichage (410), l'écran d'affichage (410) comprend la couche de détection tactile (420 ; 540), et la couche de détection tactile (420 ; 540) comprend une couche protectrice (430) ;
la zone de bouton de commande tactile comprend la couche protectrice (430) et le bouton de commande tactile.

4. Terminal de commande tactile (600) selon la revendication 3, comprenant un processeur, le processeur étant configuré pour :
détecter un signal de commande tactile sur l'écran d'affichage (410), et réaliser une première opération selon le signal de commande tactile ; et
détecter un signal de pression tactile sur le bouton de commande tactile, et réaliser une deuxième opération selon le signal de pression tactile.
